# EUROPEAN PATENT APPLICATION

(11) **EP 1 087 426 A2**
(43) Date of publication of application: **28.03.2001**
(21) Application number: 00308404.3
(22) Date of filing: 25.09.2000
(51) Int. Cl.: H01L 21/02, H01L 21/316

(54) **Integrated method and apparatus for forming an enhanced capacitor**

(30) Priority: 24.09.1999 US 405860
(71) Applicant: Applied Materials, Inc., Santa Clara, CA 95054 (US)
(72) Inventor: Narwankar, Pravin, Sunnyvale, CA 94086 (US); Sahin, Turgut, Cupertino, CA 95014 (US); Urdahl, S. Randall, Mountain View, CA 94043 (US)
(74) Representative: Allard, Susan Joyce

(57) **Abstract**

A novel method and apparatus for forming a capacitor is described. According to the present invention, a substrate having a bottom electrode is provided. A metal-oxide dielectric film is then formed on the bottom electrode. The metal-oxide dielectric film is annealed with remotely generated radicals. A metal-nitride layer is then formed on the annealed metal-oxide dielectric film. A top electrode is then formed on the metal-nitride barrier layer.

## Description

### BACKGROUND OF THE INVENTION

### 1. FIELD OF THE INVENTION

The present invention relates to the field of semiconductor processing and more specifically to an integrated method and apparatus for forming a capacitor in an integrated circuit.

### 2. DISCUSSION OF RELATED ART

Dynamic random access memories (DRAMs) are made up of literally millions of active and passive devices such as transistors, capacitors, and resistors. In order to provide more storage capability in a DRAM, device features are reduced or scaled down in order to provide higher packing density of devices. An important requirement to enable the production of future high density DRAMs is the ability to dramatically scale down capacitor size while maintaining capacitor storage. In order to increase the storage charge of a capacitor cell, high dielectric constant capacitor dielectrics are necessary.

High dielectric constant films are generally ceramic films (i.e., metal oxides) such as tantalum pentaoxide and titanium oxide. When these films are deposited they tend to have vacancies at the anionic (oxygen) cites in the lattice. Presently these vacancies are filled by annealing the film in a gas mixture which can provide an active species to occupy the lattice vacancies. For example, furnace anneals and rapid thermal oxidation (RNO) are presently used to anneal dielectric films. In such processes a substrate is placed in a furnace or a chamber of a rapid thermal heating apparatus and heated to a high temperature, greater than 800°C, while an anneal gas such as O2 or N2 is fed directly into the furnace or chamber, respectively, where the substrate is located. These processes must be performed at very high temperatures, greater than 800°C, in order to generate the active species from the annealed gas.

A problem with utilizing such high anneal temperatures is that the dielectric film such as tantalum pentaoxide crystallize when exposed to high temperatures which can lead to high leakage currents. Additionally high anneal temperatures can cause other ions to diffuse in the film, especially at the interfaces of the devices, and cause poor electrical performance. Still further many high density processes require reduced thermal budget in order to prevent or minimize dopant diffusion or redistribution in a device. Still further some processes utilize materials with low melting points which preclude subsequent use of high temperature processing.

Another problem with metal-oxide dielectric films is that barrier layers are necessary to separate metal-oxide dielectrics from metal films used to form capacitor electrodes. A barrier layer is necessary to prevent metal atoms in the capacitor electrode from stealing oxygen from the metal-oxide dielectric and causing vacancies therein which can lead to high leakage currents. It has been found that metal-nitrides, such as titanium nitrides (TiN) and tantalum nitride (TaN) provide good barriers.

Additionally, it is expected to be difficult to manufacturably integrate a metal-oxide barrier layer with metal-nitride films because of their different deposition processes and because they can interact and alter the electrical qualities and properties of the deposited films. Additionally, the integration of the metal-oxide dielectric film and a metal-nitride film into a capacitor fabrication process is expected to suffer from poor interfaces between the various layers due to oxidation and contamination of the layers as they are moved between the different process modules.

Thus, what is desired is a method and apparatus which can successfully integrate metal-oxide dielectrics, anneal steps, and metal-nitride barriers so that high density large surface area capacitors can be formed.

### SUMMARY OF THE INVENTION

A novel method and apparatus for forming a capacitor is described. According to the present invention, a substrate having a bottom electrode is provided. A metal-oxide dielectric film is then formed on the bottom electrode. The metal-oxide dielectric film is then annealed with remotely generated active atomic species. A metal-nitride layer is then formed on the annealed metal-oxide dielectric film. A top electrode can then be formed on the metal-nitride barrier layer.

### BRIEF DESCRIPTION OF THE DRAWINGS

Figure 1 is a flow chart which illustrates a process of forming a capacitor in accordance with the present invention.

Figure 2a is an illustration of a substrate including a bottom capacitor electrode.

Figure 2b is an illustration of a cross-sectional view showing exposure of to the substrate of Figure 2a to an activated atomic species.

Figure 2c is an illustration of a cross-sectional view showing the formation of a dielectric layer on the substrate of Figure 2b.

Figure 2d is an illustration of a cross-sectional view showing the formation of an annealed dielectric layer on the substrate of Figure 2b.

Figure 2e is an illustration of a cross-sectional view showing the nitrogen passivation of the substrate of Figure 2d.

Figure 2f is an illustration of a cross-sectional view showing the formation of a metal-nitride film on the substrate of Figure 2e.

Figure 2g is an illustration of a cross-sectional view showing the nitrogen radical exposure of the substrate of Figure 2f to activated nitrogen atoms.

Figure 2h is an illustration of a cross-sectional view showing the formation of a top electrode on the substrate of Figure 2g.

Figure 3a is an illustration of a apparatus which can be used to form capacitor with a high dielectric constant dielectric film in accordance with the present invention.

Figure 3b is an illustration of a chamber which can be used in the apparatus of Figure 3a.

Figure 3c is an illustration of a CVD gas delivery system which can be used to provide deposition source gas to the chamber of Figure 3b.

Figure 4a is an illustration of a cluster tool having a single integrated dielectric/anneal/barrier chamber in accordance with the present invention.

Figure 4b is an illustration of a cluster tool having discreet dielectric deposition, anneal, and barrier deposition chambers.

Figure 5 is a graph which illustrates how leakage current varies for different electrode voltages for a capacitor formed with a unannealed tantalum pentaoxide dielectric layer and for a capacitor formed with a tantalum pentaoxide dielectric layer annealed with remotely generated active atomic species.

Figure 6 is an illustration of an Arhenius plot depicting how a deposition rate varies with respect to the inverse of deposition temperature for the formation of a metal-nitride film.

Figure 7 is an illustration of a cross-sectional view of an electrode having a TiN /TaN/ TaO₅ stack formed therein.

Figure 8a is an illustration of a cross section view of an electrode having a TaO₅ / TiO/TiN film stack.

Figure 8b is an illustration of a cross section view of an electrode having a TiN /TiO / TaO₅ film stack.

### DETAILED DESCRIPTION OF THE PRESENT INVENTION

The present invention describes an integrated method and apparatus for forming a capacitor. In the following description, numerous specific details such as specific equipment configuration and process parameters are set forth in order to provide a thorough understanding of the present invention. One skilled in the art will appreciate the ability to use alternative configurations and process details to the disclosed specifics without departing from the scope of the present invention. In other instances well known semiconductor processes and equipment and methodology have not been described in detail in order to not unnecessarily obscure the present invention.

The present invention describes a novel integrated method and apparatus for forming a dynamic random access memory (DRAM) capacitor. According to an embodiment of the present invention a substrate having a bottom metal electrode is placed in a deposition chamber. The bottom electrode is then exposed to remotely generated nitrogen radicals to passivate the metal electrode. Next, a high dielectric constant metal-oxide dielectric layer such as tantalum pentaoxide (TaO₅) or titanium (Ti) doped tantalum pentaoxide (TaO₅) or titanium oxide (TiO) is formed over the electrode. The metal-oxide dielectric film is then annealed with remotely generated by activated oxygen atoms. Annealing the metal-oxide dielectric layer with activated oxygen atoms fills vacancies in the metal-oxide dielectric which helps reduce leakage current.

The annealed metal-oxide dielectric film can then be passivated by exposing the film to remotely generated activated nitrogen atoms. The activated nitrogen atoms help prevent interaction between dielectric and metal atoms subsequently used to form a metal-nitride barrier layer and thereby prevents alteration of the dielectric layer's electrical properties. Next, a metal-nitride barrier layer such as but not limited to tantalum nitride (TaN) or titanium nitride (TiN) is formed on the passivated metal-oxide dielectric. In one embodiment of the present invention the barrier layer is formed by thermally disassociating a metal source to form metal atoms and combining the metal atoms with remotely generated activated nitrogen atoms to form the metal-nitride barrier layer. The metal-nitride barrier layer can then be exposed to activated nitrogen atoms in order to "stuff" the metal-nitride film with nitrogen and thereby prevent subsequent oxidation thereof. Finally, a top electrode can be formed over the metal-nitride layer, if necessary, to complete fabrication of the capacitor.

In one embodiment of the present invention, the metal-oxide dielectric formation step, the anneal step, and the barrier formation step occur in a single chamber of a thermal heating apparatus which is coupled to receive activated (reactive) nitrogen and or oxygen atoms from a remote disassociation chamber. Integrating the dielectric formation step, the anneal step, and the barrier formation step into a single chamber enables a consistent, high quality capacitor cell to be formed across a wafer and from wafer to wafer. Utilizing the same deposition chamber enables a very smooth interface between the various layers because the substrate is never exposed to an ambient outside the chamber. Additionally, utilizing the same deposition chamber enables consistent temperature and pressures profiles to be generated since they are generated utilizing the exact same hardware (e.g., lamps, heaters, flow controllers and pumps, etc.). Still further, integrating the above steps into a single deposition chamber decreases the cost of ownership in that it enables a smaller footprint than possible if multiple independent chambers were utilized.

In another embodiment of the present invention, the metal-oxide dielectric deposition step, the anneal step and the barrier fabrication steps, occur in separate chambers of a single "cluster tool". In such a "cluster tool" a metal-oxide deposition chamber, an anneal chamber, and a barrier deposition chamber are each coupled together by a common transfer chamber. In this way, wafers or substrates can be moved from one chamber to the next at reduced pressures and/or in inert ambients so that wafers are not exposed to an oxygen ambient or other contaminants during the capacitor fabrication steps.

The integrated method and apparatus of the present invention enables the formation of high quality, high dielectric constant metal-oxide dielectric layers and high quality, low resistance metal-nitride barrier layers at low temperatures, less than 500°C, and into high aspect ratio openings (greater than 2:1). The integrated process of the present invention enables the fabrication of an enhanced performance capacitors which will be necessary in future generations of ultra high density dynamic random access memories (DRAMs). The integrated process and apparatus of the present invention is expected to enable the production of DRAM capacitors at densities greater than 4 Gb.

### Integrated Apparatus for Formation of a Capacitor

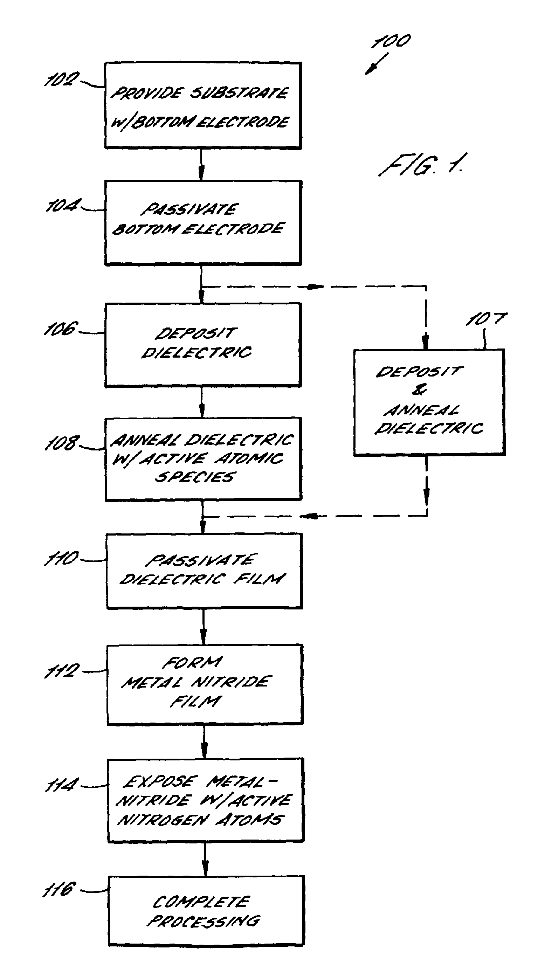

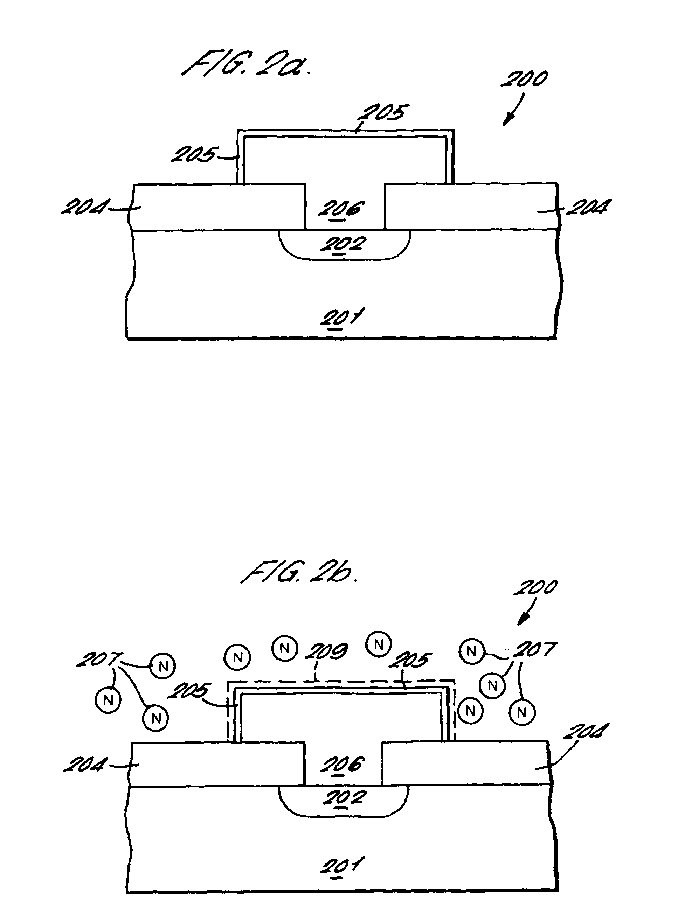

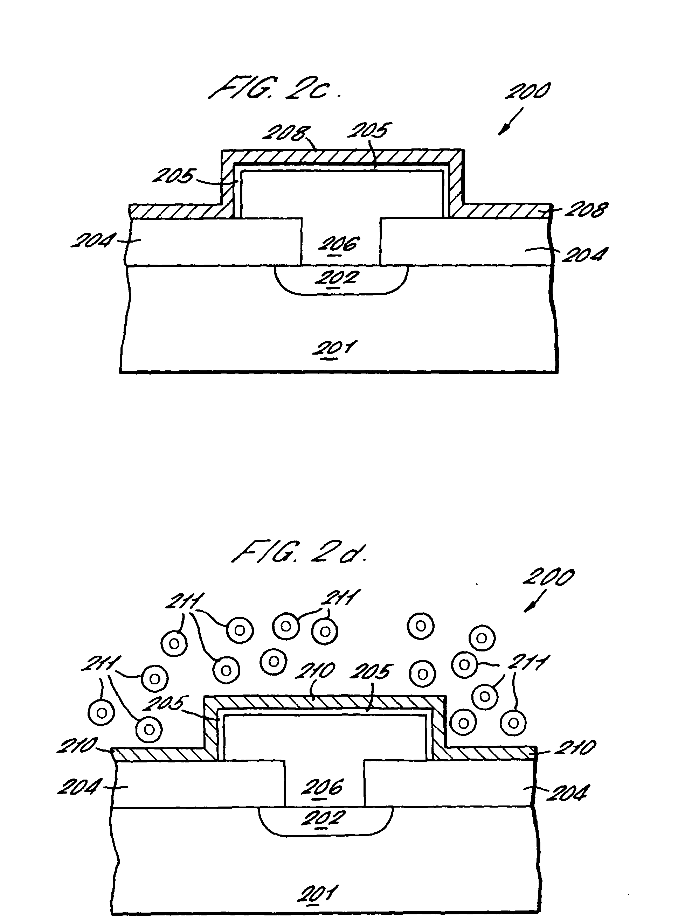

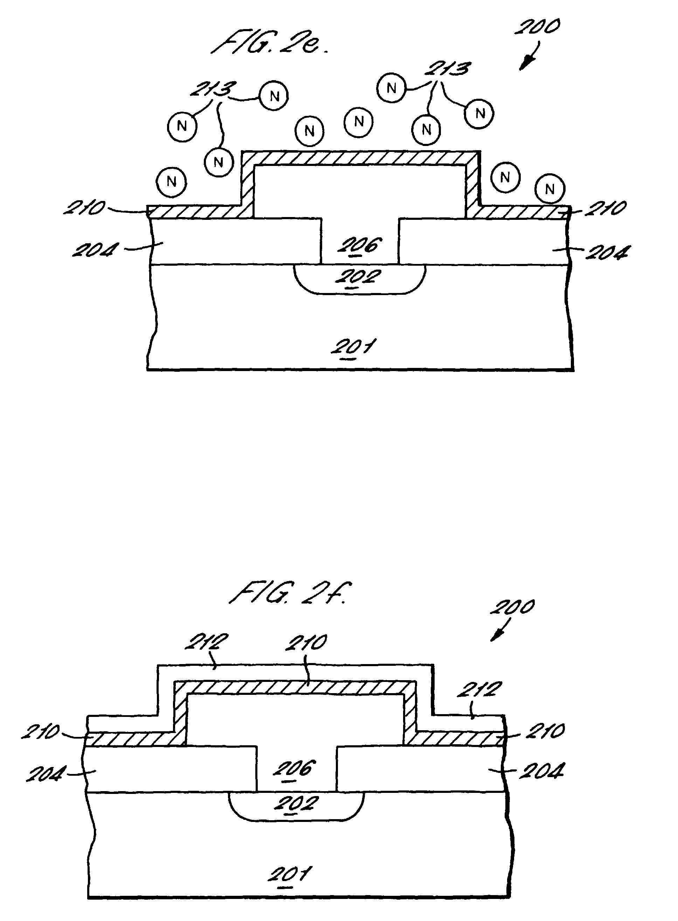

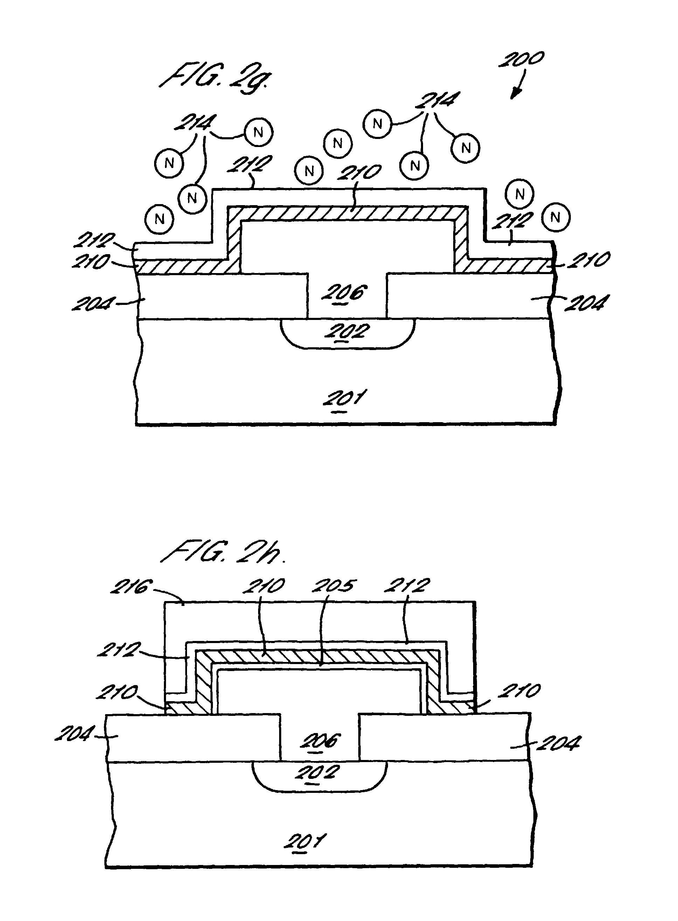

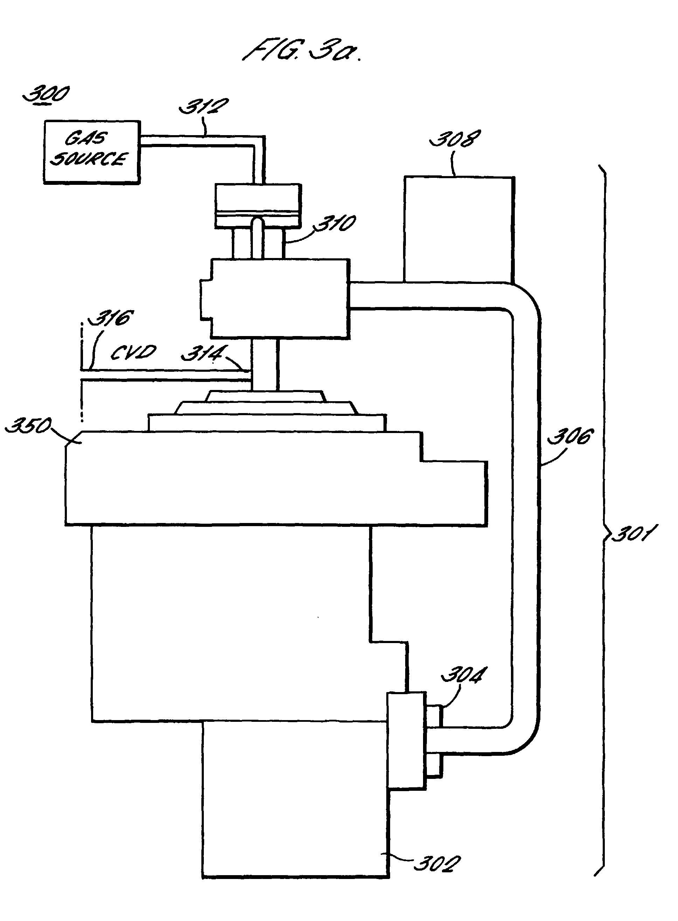

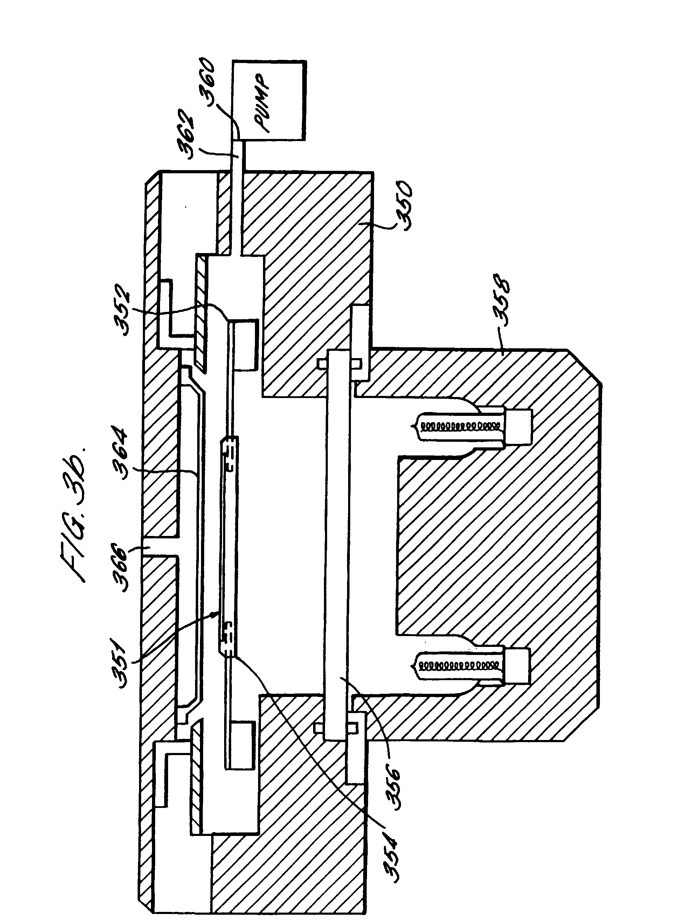

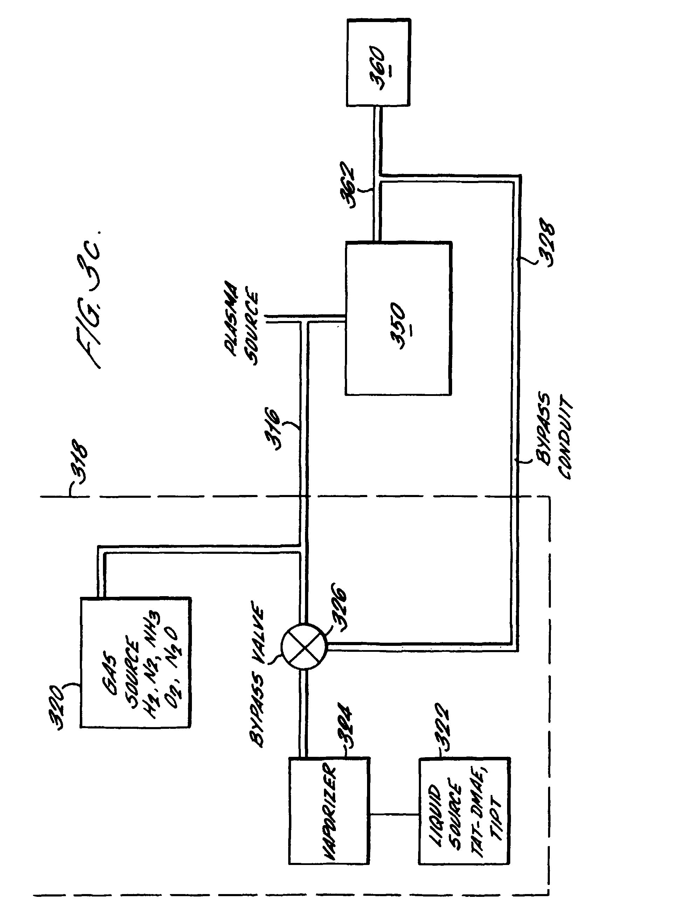

An example of an apparatus 300 which can be used to deposit, anneal, and passivate films in accordance with the present invention is illustrated in Figures 3a and 3b. An example of a commercially available apparatus which can be used to provide active atomic species is the Applied Materials Centura Advanced Strip Passivation Plus (ASP) chamber. Apparatus 300 includes a remote plasma generator 301 which generates and provides active atomic species to a process chamber 350 in which the substrate to be passivated or annealed is located. Remote plasma generator 301 includes a magnatron 302 which generates microwaves with a microwave source. Magnatron 302 can preferably generate up to 10,000 watts of 2.5 Ghz microwave energy. It is to be noted that the amount of power required is dependent (proportional) to the size of anneal chamber 350. For an anneal chamber used to process 300mm wafers, 10,000 watts of power should be sufficient. Although a microwave source is used to generate a plasma in apparatus 300, other energy sources such as radio frequency (RF) may be used.

Magnatron 302 is coupled to an isolator and dummy load 304 which is provided for impedance matching. The dummy load absorbs the reflected power so no reflective power goes to the magnatron head. Isolator and dummy load 304 is coupled by a wave guide 306, which transmits microwave energy to an autotuner 308. Autotuner 308 consist of an impedance matching head and a separate detector module that uses three stepper motor driven impedance matching stubs to reduce the reflective power of the microwave energy directed to the power source. Autotuner 308 focuses the microwave energy into the center of a microwave applicator cavity (or chamber) 310 so that energy is absorbed by annealed gas fed into the applicator cavity 310. Although an autotuner is preferred a manual tuner may be employed. Applicator 310 uses microwave energy received from magnatron 302 to create a plasma from the anneal gas as it flows down through a quartz plasma tube located inside applicator 310. A source 312, such as a tank, of an anneal gas such as but not limited to O₂, N₂O, and N₂ used for generating the active atomic species is coupled to microwave applicator 310. Additionally, a source of an inert gas such as argon (Ar) or helium (He) can also be coupled to applicator 310. A prefire mercury lamp can be used to radiate ultraviolet light into the plasma tube to partially ionize the process gases and thereby make it easier for the microwave energy to ignite the plasma.

The microwave energy from magnetron 302 converts the anneal gas into a plasma which consist of essentially three components; ionized or charged atoms (radicals), electrically neutral activated (reactive) atomic species, and nondissociated anneal gas. For example when O₂ is the anneal gas, microwave energy disassociates the O₂ gas into oxygen radicals, reactive oxygen atoms, and some anneal gas remains as O₂ molecules. When N₂ is the anneal gas, microwaves disassociate the N₂ gas into nitrogen radicals, electrically neutral reactive nitrogen atoms, and some anneal gas remains as N₂ molecules. Reactive atomic species such as reactive oxygen atoms or reactive nitrogen atoms are not charged or ionized but are highly energized electrically neutral atoms. Because the reactive atomic species are highly energized they are in a highly reactive state so they readily react with dielectric films to fill vacancies therein or to passivate films or substrates. Because the atomic species are highly energized when they enter anneal chamber 350, high temperatures are not necessary in chamber 350 to activate the anneal gas.

Applicator 310 is bolted to the lid of chamber 350. The concentrated plasma mixture flows downstream through conduit 314 to chamber 350. As a plasma flows through the conduit 314 the ionized atoms become electrically neutral before reaching chamber 350 and become highly reactive atomic species. Thus, only electrically neutral, highly reactive atoms flow into chamber 350. Although the process gas at this point is highly reactive, the mixture is no longer electrically damaging to the substrate or electrical devices such as transistors formed therein. Because the active atomic species are generated at location (chamber 310) which is separate or remote from the chamber 350 in which the substrate to be annealed is located, the active atomic species are said to be "remotely generated".

Chamber of 350 of apparatus 300, as shown in Figure 3b, includes a wafer support 352 for supporting a wafer or substrate 351 face up in chamber 350. Wafer support 352 can include an aluminum chuck 354. Chamber 350 includes a quartz window 356 through which infrared radiation from a plurality (14) of quartz tungsten halogen lamp 358 is transmitted. During processing, the lamps mounted directly below the process chamber radiantly heat the chuck which in turn heats the wafer by conduction. A closed loop temperature control system senses the temperature of the substrate or wafer using a thermocouple mounted in the chuck. The temperature control system regulates the temperature of the wafer by varying the intensity of lamps 358. Although lamps are shown as the heat source for heating the chuck, other heat sources, such as resistive heaters, can be used. A vacuum source 360, such as the pump, is coupled to an exhaust outlet 362 and controls the chamber pressure and removes gas by products. A shower head or gas distribution plate 364 is mounted directly above the wafer. Shower head 364 consist of three quartz plates having a plurality of holes formed therein to evenly distribute the active atomic species over the wafer as they flow through gas inlet 366.

In embodiments of the present invention, chamber 350 is also configured to receive deposition gases used to deposit a film by chemical vapor deposition (CVD). In this way, a dielectric film can be annealed in the same chamber as used to deposit the film, or the dielectric film can be annealed as it is deposited.

Figure 3c illustrates an example of a CVD gas delivery system 318 which can be used to provide deposition gas and anneal gas to chamber 350. CVD gas delivery system 318 is coupled by conduit 316 to conduit 314. CVD gas delivery system 318 includes a source of gas 320 such as a plurality of tanks of for example H₂, N₂, NH₃, O₂, N₂O, which are used to deposit and or anneal films in chamber 350. Gas delivery system 318 also includes a source of deposition liquids 322, such as TAETO, TAT-DMAE, TIPT, and the vaporizor 324 in order to provide vaporized liquid for deposition of films in chamber 350 gas delivery system 318 also includes a by pass valve 326. In one position by pass valve 326 allows vaporized liquid to flow into conduit 316 and into chamber 350. In a second position by pass valve 326 diverts the flow of vaporized liquid into by pass conduit 328 which is coupled to exhaust outlet 362 of chamber 350. By pass valve 326 and by pass conduit 328 allow vaporized gas to be directed to exhaust when a vaporized liquid is not needed in chamber 350. In this way a steady state flow of vaporized liquid is always maintained and available for chamber 350 when required.

It is to be appreciated that other thermal processing chambers such as the Applied Material's Poly Centura single wafer chemical vapor deposition reactor or the Applied Material's RTP Centura with the Honeycomb Source, each configured to receive active atomic species from remote plasma generator 301, can be used on place of chamber 350.

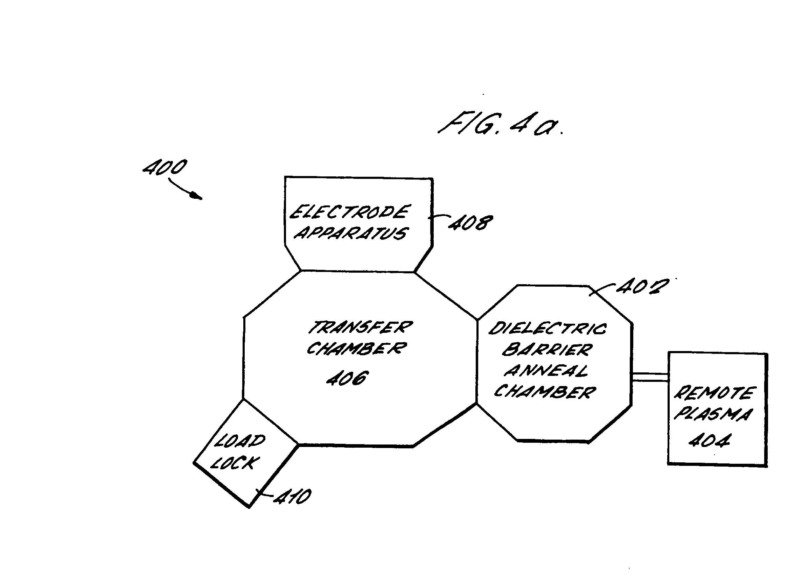

In one embodiment of the present invention, as shown in Figure 4a, a single thermal heating apparatus 402, such as heating apparatus 300 shown in Figure 3a is used to form a metal-oxide dielectric, anneal the dielectric, and alternately form a metal-nitride barrier layer. Thermal heating apparatus 402 is coupled to receive activated atoms from a remote plasma generator 404 such as remote plasma generator 301 shown in Figure 3a. The process chamber of thermal heating apparatus 402 can be part of a cluster tool 400 which includes a load lock 410, a transfer chamber 406, and other deposition chambers such as an electrode deposition chamber 408. Transfer chamber 406 can include a robot arm to transfer wafers or substrates between various chambers of cluster tool 400. Each chamber in cluster tool 400 contains a vacuum sealable chamber door coupled to transfer chamber 406 to enable substrates to be transferred between the process chambers and the transfer chamber. Transfer chamber 406 can include a pump to reduce the pressure within the transfer chamber and to remove an oxygen ambient. Additionally transfer chamber 400 can include a gas inlet to provide an inert ambient such as N₂ in transfer chamber 406. In this way substrates can be transferred between the various chambers of the cluster tool without being exposed to an oxygen ambient.

In another embodiment of the present invention as shown in Figure 4b, the capacitor fabrication process is carried out in a cluster tool 450 which includes a separate thermal metal-oxide dielectric deposition apparatus 456, a separate anneal apparatus 452 and a separate barrier deposition apparatus 460 or combinations thereof. Cluster tool 450 includes other chambers such as, a transfer chamber 458, a load lock 410 and can include other deposition chambers such as an electrode deposition chamber 408. The metal-oxide dielectric deposition apparatus 456, the anneal apparatus 452, and the metal-nitride deposition apparatus 460 can each be a thermal processing apparatus which has a source for remotely activating activated atomic species such as apparatus 300 shown in Figure 3a. Although the present invention will be described with respect to the use processing apparatus 300 shown in Figures 3a and 3b it is to be appreciated that other suitable processing apparatuses and active species generators can also be utilized.

### Integrated Process of Forming a Capacitor

A method of forming an a capacitor in accordance with the present invention will now be described in reference to Figure 1 and Figures 2a-2h. Figure 1 illustrates a flow chart which depicts a process of forming a capacitor in accordance with the present invention. Figure 2a-2h illustrate cross-sectional views of a substrate showing the fabrication of a capacitor of a DRAM cell in accordance with the present invention. It is to be appreciated that these specific details are only illustrative of an embodiment of the present invention and are not to be taken as limiting to the present invention.

A first step, as set forth in block 102 of flow chart 100, of forming a capacitor in accordance with the present invention is to provide a substrate with a bottom electrode. For the purpose of the present invention a substrate is the starting material on which films are deposited and processes act in accordance with the present invention.

According to the present invention, the substrate is a substrate used in the fabrication of a dynamic random access memory (DRAM) cells such as substrate 200 shown in Figure 2a. Substrate 200 includes well known silicon epitaxial substrate 201 having a doped region 202 formed therein and a pattern interlayer dielectric 204 formed thereon. A bottom capacitor electrode 206 is formed in contact with the diffusion region 202 and over ILD 204. Bottom capacitor electrode 206 can be formed by any well known technique such as by blanket depositing an electrode film by chemical vapor deposition (CVD) or sputtering and then patterning the blanket deposited material into an electrode by well known photolithography and etching techniques. In an embodiment of the present invention electrode 206 is a silicon (polysilicon) electrode doped to a density between 2-5x10 20 atoms/cm³. It is to be appreciated that a silicon bottom electrode 206 can take the form of high surface area hemispherical grained polysilicon (HSG) or *"rough poly"* if desired. In another embodiment of the present invention bottom electrode is a metal electrode formed from a metal such as but not limited to tungsten (W), titanium (Ti), tantalum (Ta), titanium tungsten (TiW) titanium-nitride (TiN) and tungsten nitride (WN). In still another embodiments, of the present invention the monocrystalline silicon substrate 201 can act as the bottom electrode.

Additionally, in embodiment of the present invention, bottom electrode 200 includes, an outer silicon nitride or metal nitride layer 205. If bottom electrode 200 comprises an outer silicon layer, then a silicon nitride film 205 can be formed by nitridating bottom electrode 206. A thin silicon nitride layer can be formed by exposing substrate 200 to remotely generated reactive nitrogen atoms in chamber 350 while substrate 200 is heated to a temperature between 700-900°C and chamber 350 maintained at a pressure between .5 torr to 2 torr. Reactive nitrogen atoms can be formed by flowing between 0.5 to 2.0slm of N₂ or ammonia (NH₃) into cavity 310 and applying a power between 1400 to 5000 watts to magnatron 302 to create a plasma from the N₂ and NH₃ gas in cavity 310. The nitridation process forms silicon nitride only on those locations where silicon is available to react with reactive nitrogen atoms such as silicon electrode 206 and not on those areas where silicon is unavailable for reaction such as ILD 204. A suitable silicon nitride layer 205 can be formed from a silicon electrode by nitridating silicon 200 with remotely generated reactive nitrogen atoms for between 30 to 120 seconds. Alternatively, a thin silicon nitride layer 205 can be formed from a silicon electrode by other well known techniques such as by thermal-nitridization wherein substrate 200 is heated and exposed to an ambient comprising ammonia (NH₃). In an alternative embodiment of the present invention a silicon nitride barrier layer 205 can be formed by blanket depositing a silicon nitride film 205 by low pressure chemical vapor deposition (LPCVD) utilizing a chemistry comprising ammonia (NH₃) and silane (SiH₄). Such a deposition technique will deposit silicon nitride on all surfaces of substrate 200 including ILD 204 and electrode 206.

Alternatively, if the outermost surface of bottom electrode 206 is a metal film, such as titanium, tantalum, and tungsten, then a metal nitride barrier layer (e.g. TiN, TaN, WN) can be formed by nitridation of substrate 200. For example, a thin metal nitride layer 205 can be formed by nitridating substrate 200 by exposing substrate 200 to remotely generated reactive nitrogen atoms in the chamber 350 while substrate 200 is heated. Reactive nitrogen atoms can be formed by flowing between 1-5 slm of Nitrogen (N₂) or ammonia (NH₃) into cavity 310 and applying power to magnatron 302 to create a plasma from the N₂ or NH₃ gas in cavity 310. The nitradation process forms a metal nitride layer only on those locations where metal is available to react with the reactive nitrogen atoms, such as the outer surface of electrode 206 and not on those areas where no metal is available for reaction such as ILD 204. A suitable metal nitride area layer 205 can be formed from a metal electrode by nitridating substrate 200 with remotely generated reactive nitrogen atoms for between 30-120 seconds. Alternatively, a thin metal nitride barrier layer 205 can be formed from a metal electrode by other well known techniques such as by thermal nitridation by heating substrate 200 and exposing substrate 200 to ambient comprising ammonia.

Next, as set forth in step 104 of flow chart 100, in an embodiment of the present invention, substrate 200 is passivated with remotely generated reactive nitrogen atoms, as shown in Figure 2b, to cure defects in silicon nitride or metal nitride barrier layer 205. Silicon nitride or metal nitride barrier layer 205 can be passivated by placing substrate 200 on chuck 354 in chamber 350 and heating substrate 200 to a temperature between 300-500 while an N₂ anneal gas is fed into cavity 310 at a rate of between 0.5-2 slm and a power of between 1400-5000 watts is provided to magnatron 302. Microwaves from magnatron 302 create a plasma in cavity 310 from the N₂ process gas. Highly reactive electrically neutral nitrogen atoms 207 then flow through conduit 314 into chamber 350 where they passivate 209 nitride barrier layer 205. Exposing substrate 200 to active nitrogen atoms 207 can be used to stuff the capacitor electrode 206 with nitrogen atoms and thereby prevent subsequent oxidation of the capacitor electrode. Silicon nitride or metal nitride barrier layer 205 can be sufficiently passivated by exposing substrate 200 to remotely generated reactive nitrogen atoms for between 30-120 seconds. Alternatively, silicon nitride barrier layer 205 can be passivated by subsituting forming gas (3-10% H2 and 97-90% N₂) for the N₂ anneal gas. The addition of hydrogen (H₂) helps to cure defects and to remove contaminates.

Next, as set forth in block 106, a dielectric film is formed over substrate 200. In one embodiment of the present invention a high dielectric constant dielectric film 208 is blanket deposited over ILD 204 and bottom electrode 206 of substrate 200 as shown in Figure 2c. In an embodiment of the present invention the dielectric film is a transition metal dielectric film such as, but not limited to, tantalum pentaoxide (Ta₂O₅) and titanium oxide (TiO₂). In another embodiment dielectric layer 208 is a tantalum pentaoxide film doped with titanium. Additionally dielectric layer 208 can be a composite dielectric film comprising a stack of different dielectric films such as a Ta₂O₅/TiO₂/ Ta₂O₅ stacked dielectric film. Additionally, dielectric layer 208 can be a piezoelectric dielectric such as Barium Strontium Titanate (BST) and Lead Zerconium Titanate (PZT) or a ferroelectric.

In other embodiments of the present invention dielectric layer 208 can be silicon dioxide, silicon nitride, silicon oxy-nitride, or a composite oxide/nitride dielectric stack such as well known ONO and NO dielectric stacks. The fabrication of such oxides are well known and can be used in the fabrication of gate dielectric layers and capacitor dielectrics. For example a low temperature silicon dioxide film can be formed by chemical vapor deposition utilizing a silicon source, such as TEOS, and an oxygen source, such as O₂. A silicon nitride film can be formed as described above.

To blanket deposit a tantalum pentaoxide (Ta₂O₅) dielectric film by thermal chemical vapor deposition a deposition gas mix comprising, a source of tantalum, such as but not limited to, TAETO [Ta (OC₂H₅)₅] and TAT-DMAE [Ta (OC₂H₅)₄ (OCHCH₂ N(CH₃)₂], and source of oxygen such as O₂ or N₂O can be fed into a deposition chamber while the substrate is heated to a deposition temperature of between 300-500°C and the chamber maintained at a deposition pressure of between 0.5 -10 Torr. The flow of deposition gas over the heated substrate results in thermal decomposition of the metal organic Ta-containing precursor an subsequent deposition of a tantalum pentaoxide film. In one embodiment TAETO or TAT-DMAE is fed into the chamber at a rate of between 10 - 50 milligrams per minute while O₂ or N₂O is fed into the chamber at a rate of 0.3 - 1.0 slm. TAETO and TAT-DMAE can be provided by direct liquid injection or vaporized with a bubbler prior to entering the deposition chamber. A carrier gas, such as N₂, H₂ and He, at a rate of between 0.5-2.0 slm can be used to transport the vaporized TAETO or TAT-DMAE liquid into the deposition chamber. Deposition is continued until a dielectric film 508 of a desired thickness is formed. A tantalum pentaoxide (Ta₂O₅) dielectric film having a thickness between 50-200 Å provides a suitable capacitor dielectric.

It has been found that the use of nitrous oxide (N₂O) as the oxidizer (source of oxygen), as opposed to oxygen gas O₂ improves the electrical properties of the deposited tantalum pentaoxide (Ta₂O₅) dielectric film. The use of N₂O, as opposed to O₂, has been found to reduce the leakage current and enhance the capacitance of fabricated capacitors. The inclusion of N₂O as an oxidizer aids in the removal of carbon from the film during growth which helps to improve the quality of the film.

In an embodiment of the present invention dielectric layer 208 is a tantalum pentaoxide (Ta₂O₅) film doped with titanium (Ti). A tantalum pentaoxide film doped with titanium can be formed by thermal chemical vapor deposition by providing a source of titanium, such as but not limited to TIPT (C₁₂H₂₆O₄Ti), into the process chamber while forming a tantalum pentaoxide film as described above. TIPT diluted by approximately 50 % with a suitable solvent such as isopropyl alcohol (IPA) can be fed into the process chamber by direct liquid injection or through the use of a bubbler and carrier gas such as N₂. A TIPT diluted flow rate of between 5-20 mg/minute can be used to produce a tantalum pentaoxide film having a titanium doping density of between 5-20 atomic percent and a dielectric constant between 20-40. The precise Ti doping density can be controlled by varying the tantalum source flow rate relative to the titanium source flow rate. It is to be appreciated that a tantalum pentaoxide film doped with titanium atoms exhibits a higher dielectric constant than an undoped tantalum pentaoxide film.

In another embodiment of the present invention dielectric layer 208 is a composite dielectric layer comprising a stack of different dielectric materials such as a Ta₂O₅/TiO₂/Ta₂O₅ stack. A Ta₂O₅/TiO₂/Ta₂O₅ composite film can be formed by first depositing a tantalum pentaoxide film as described above. After depositing a tantalum pentaoxide film having a thickness between 20-50 Å the flow of the tantalum source is stopped and replaced with a flow of a source of titanium, such as TIPT, at a diluted flow rate of between 5-20mg/min. After depositing a titanium oxide film having a thickness of between 20-50 Å, the titanium source is replaced with the tantalum source and the deposition continued to form a second tantalum pentaoxide film having a thickness of between 20-50 Å. By sandwiching a higher dielectric constant titanium oxide (TiO₂) film between two tantalum pentaoxide (Ta₂O₅) films, the dielectric constant of a composite stack is increased over that of a homogeneous layer of tantalum pentaoxide (Ta₂O₅).

Next, as set forth in block 108 of flow chart 100, dielectric film 208 is annealed with remotely generated active atomic species 211 as shown in Figure 2d, to form an annealed dielectric layer 210. Dielectric film 208 can be annealed by placing substrate 200 into anneal chamber 350 coupled to remote plasma generator 301. Substrate 200 is then heated to an anneal temperature and exposed to active atomic species 211 generated by disassociating an anneal gas in applicator chamber 310. By generating the active atomic species in a chamber remote from the anneal chamber (the chamber in which the substrate is situated) a low temperature anneal can be accomplished without exposing the substrate to the harmful plasma used to form the active atomic species. With the process and apparatus of the present invention anneal temperatures of less than 400°C can be used. The use of remotely generated active atomic species to anneal dielectric film 208 enables anneal temperatures of less than or equal to the deposition temperature of the dielectric film to be used.

In one embodiment of the present invention dielectric film 208 is a transition metal dielectric and is annealed with reactive oxygen atoms formed by remotely disassociating O₂ gas. Dielectric layer 208 can be annealed in chamber 350 with a reactive oxygen atoms created by providing an anneal gas comprising two slm of O₂ and one slm of N₂ into chamber 310, and applying a power between 500 - 1500 watts to magnatron 302 to generate microwaves which causes a plasma to ignite from the anneal gas. Alternatively, reactive oxygen atoms can be formed by flowing an anneal gas comprising two slm of O₂ and three slm of argon (Ar) into cavity 310. While reactive oxygen atoms are fed into anneal chamber 350, substrate 200 is heated to a temperature of approximately 300°C and chamber 350 maintained at an anneal pressure of approximately 2 Torr. Dielectric layer 208 can be sufficiently annealed by exposing substrate 200 to reactive oxygen atoms for between 30-120 seconds.

An inert gas, such as Nitrogen N₂ or argon (Ar), is preferably included in the anneal gas stream in order to help prevent recombination of the active atomic species. It is to be noted that as the active atomic species (e.g. reactive oxygen atoms) travel from the applicator cavity 310 to the anneal chamber 350, they collide with one another and recombine to form O₂ molecules. By including an inert gas, in the anneal gas mix, the inert gas does not disassociate and so provides atoms which the active atomic species can collide into without recombining. (It is to be appreciated that at a power between 500-1500 watts N₂ does not disassociate on so can be considered a inert gas) Additionally, in order to help prevent recombination of the active atomic species, it is advisable to keep the distance between cavity 310 and anneal chamber 350 as short as possible.

Annealing a transition-metal dielectric film 208 with reactive atoms oxygen fills oxygen vacancies (satisfies sites) in the dielectric film 208 which greatly reduces the leakage of the film. Additionally, annealing transition metal dielectric 208 helps to remove carbon (C) in the film which can contribute to leakage. Carbon can be incorporated into transition metal dielectrics because the tantalum and titanium sources, TAT-DMAE, TAETO, and TIPT are carbon containing compounds. The reactive oxygen atoms remove carbon from the film by reacting with carbon and forming carbon dioxide (CO₂) vapor which can then be exhausted out from the chamber.

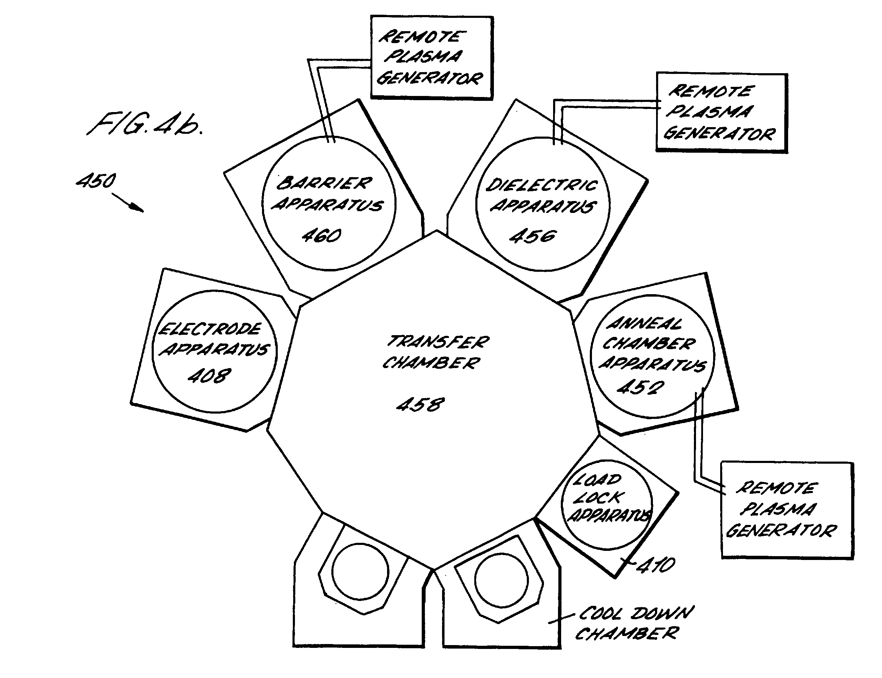

Figure 5 illustrates how exposing a tantalum pentaoxide dielectric film to remotely generated reactive oxygen atoms improves the quality and electrical performance of the as deposited film. Graph 502 shows how the leakage current of a capacitor having a 100Å unannealed tantalum pentaoxide dielectric film varies for different top electrode voltages. Graph 504 shows how the leakage current of a capacitor having a 100Å tantalum pentaoxide dielectric film annealed with remotely generated reactive oxygen atoms varies for different top electrode voltages. As can be seen from graph 502, a capacitor utilizing an unannealed tantalum pentaoxide dielectric experiences high leakage current of about 1x 10 ⁻¹(amps/cm²) when ± 1.5 volts is applied to the top electrode and a high leakage current of 1x10 ⁻⁶ (amps/cm²) when zero volts is applied to the top electrode. In comparison, when the tantalum pentaoxide dielectric is exposed to remotely generated reactive oxygen atoms, the leakage current has a relatively low leakage current of 1x10⁻⁵ (amps/cm²) when ± 1.5 volts is applied to the top electrode and a leakage current of less than 1x10⁻⁹ (amps/cm²) when zero volts is applied to the top electrode. As is readily apparent from Figure 5, exposing the tantalum pentaoxide dielectric film to remotely generated active oxygen atoms dramatically improves (reduces) the leakage current of the film.

In an embodiment of the present invention, as set forth in block 107 of flow chart 100 the deposition step 106 and the anneal step 108 occur simultaneously so that the dielectric film is annealed as it is deposited. A dielectric film can be deposited and annealed simultaneously using a single deposition/anneal chamber coupled to receive a remote plasma from a remote plasma generator source and coupled to receive a deposition gas mix. For example in one embodiment of the present invention a deposition gas mix comprising a metal source such as a TAT-DMAE or TIPT, or a silicon source, such as TEOS, and a source of oxygen such as O₂ or N₂O can be fed into a common anneal/deposition chamber while the substrate is heated to a desired deposition temperature and the chamber maintained at a desired deposition pressure. Simultaneously, an anneal gas, such as O₂, can be supplied into applicator cavity chamber 310 of the remote plasma generator 300 at a rate of between 0.5 - 2 slm. Reactive oxygen atoms can then flow from chamber 310 into the anneal/deposition chamber. The reactive oxygen atoms then react with the metal or silicon provided from the deposition gas mix to form a metal-oxide or silicon-oxide compound respectively. In one embodiment of the present invention the only source of oxygen atoms into the deposition / anneal chamber 350 is reactive oxygen atoms from applicator 310.

Next, as set forth in block 110 and illustrated in Figure 2e, dielectric layer 208 is passivated with remotely generated highly reactive nitrogen atoms 213 prior to depositing a metal-nitride film. Metal-oxide dielectric 210 can be passivated by placing substrate 200 into chamber 350 and then exposing substrate 200 to highly reactive nitrogen atoms 210 formed by disassociating a nitrogen containing gas, such as but not limited to N₂, and NH₃, in disassociation chamber 310 of remote plasma generator 300. Exposing substrate 200 to remotely generated activated nitrogen atoms passivates dielectric film 208 with nitrogen atoms. Passivating dielectric film 208 with activated nitrogen atoms prevents metal atoms provided during the subsequent metal-nitride deposition step from diffusing into the dielectric film and causing uncontrolled alterations of film properties.

For example, if a titanium nitride (TiN) film is to be formed onto a tantalum pentaoxide (TaO₅) dielectric film, if the dielectric film was not first passivated with activate nitrogen atoms, then titanium could diffuse into the tantalum pentaoxide film and form titanium oxide compounds which could affect the electrical properties of the film. By initially passivating dielectric film 210 with activated nitrogen atoms 213, nitrogen is readily available to react with the metal atoms and thereby prevent the metal atoms from diffusing into the dielectric film and causing undesired alteration of film properties.

Dielectric film 210 can be sufficiently passivated by exposing substrate 200 highly reactive nitrogen atoms for between 10-60 seconds while substrate 200 is heated to a temperature between 350-450°C while chamber 350 is maintained at a pressure of less than 10 torr. Reactive nitrogen atoms can be formed by feeding between 1-5 slm of N₂ or NH₃ gas into applicator 310 and disassociating the gas with microwaves or RF.

Next, as set forth in block 112 of flow chart 100 and shown in Figure 2g, a metal-nitride film 212 is formed on nitrogen passivated dielectric film 210.

In one embodiment of the present invention the metal nitride film 212 is titanium nitride formed by thermal chemical vapor deposition. A titanium nitride film can be formed by thermal chemical vapor deposition onto dielectric layer 208 by providing titanium tetrachloride (TiCl₄) and ammonia (NH₃) into deposition chamber 350 while substrate 200 is heated to a temperature between 550-680°C. TiCl₄ can be fed into deposition chamber 350 by direct liquid injection or through the use of a bubbler. Heat from substrate 200 causes the titanium tetrachloride (TiCl₄) to decompose and provide titanium atoms and causes the ammonia (NH₃) to decompose and provide nitrogen atoms. The nitrogen atoms and the titanium atoms then combine together to form a titanium nitride film.

In a preferred embodiment of the present invention the flow of TiCl₄ is fed into chamber 350 prior to beginning the flow of ammonia (NH₃) into chamber 350. In this way the substrate 200 is titanium rich, and sufficient titanium is available to react with the ammonia as it flows into the chamber. When ammonia (NH₃) enters the chamber it breakdown into nitrogen, N-H molecules and hydrogen atoms. If hydrogen atoms are able to react with the metal oxide dielectric they can reduce the metal oxide (TaO₅) into metal (Ta) which can cause the metal oxide dielectric to have high leakage. By saturating substrate 200 with titanium prior to beginning the flow of ammonia (NH₃), titanium nitride forms immediately and prevents hydrogen from reducing the metal oxide dielectric.

To deposit a metal-nitride film in accordance with another embodiment of present invention, a source of metal atoms such as but not limited to a metal organic precursors such as TiPT (C₁₂ H₂₆ O₄ Ti), TAETO [Ta (OC₂H₅)₅], TAT-DMAE [Ta (OC₂H₅)₄ (OCHCH₂ N(CH₃)₂], is fed into a deposition chamber 350 along with highly activated nitrogen atoms formed in disassociation chamber 310. Heat from substrate 200 causes the metal organic precursor to disassociate and provide metal atoms which combine with the highly activated nitrogen atoms to form a metal-nitride film 212. The deposition temperature of the substrate should be sufficient to thermally decompose the metal source without the use of additional decomposition sources such as plasma or photon enhancement.

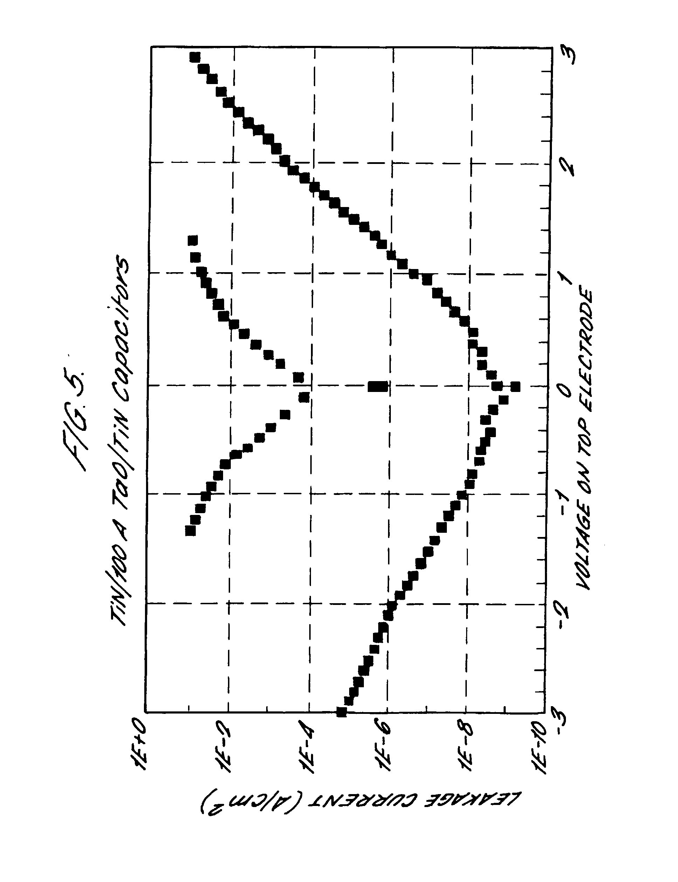

In an embodiment of the present invention, the deposition temperature (temperature of the substrate) is chosen to be in the region of *"slope"* for an Arhenius plot of the metal-nitride film. For example, Figure 6 illustrates Arhenius plot for a metal-nitride film wherein the deposition rate of the film is plotted against the inverse of the deposition temperature (1/T). As shown in Figure 6, the deposition rate is constant for deposition temperatures greater than Tₛ where as for temperatures less than Tₛ (i.e., the slope portion 602 of the plot) the deposition rate falls with decreases in deposition temperature. By operating at a deposition temperature in the *"slope region"* the reaction of the metal with highly activated nitrogen atoms is not immediate. By lowering deposition temperature and slowing down the reaction, metal atoms are able to migrate into the high aspect ratio openings before reacting with the highly reactive nitrogen atoms. In this way high aspect ratio openings greater than 2:1 and even as high as 5:1 can be reliably filled with a metal-nitride film.

A titanium nitride (TiN) film can be formed by flowing a titanium organic precursor such as but not limited to TiPT (C₁₂ H₂₆ O₄ Ti), into deposition chamber 250 at a rate of between 5 - 100 milligrams/minute while the substrate is heated to a deposition temperature of between 350-450°C with a deposition chamber pressure of between 1-5 torr while activated nitrogen atoms generated in chamber 310 are fed into deposition chamber 350 at a rate of between 1-5 slm. Activated nitrogen atoms can be generated by feeding between 1-5 slm of N₂ or NH₃ into chamber 310 and disassociating the gas with microwaves or RF. The titanium organic precursor can be fed into chamber 13 by direct liquid injection or through the use of a bubbler. Such conditions can produce a uniform and conformal titanium nitride film in high aspect ratio openings at a rate of between 10-100 angstroms/minute.

A tantalum nitride film can be formed by flowing a tantalum organic precursor such as but not limited to TAETO [Ta (OC₂H₅)₅], and TAT-DMAE [Ta (OC₂H₅)₄ (OCHCH₂ N(CH₃)₂], into deposition chamber 350 at a rate of between 10-50 mg/min while the substrate is heated to a deposition temperature of between 350-500°C with a deposition chamber pressure of between 1-5 torr while activated nitrogen atoms are fed into the deposition chamber 350 at a rate of between 1-5 slm. Activated nitrogen atoms can be generated by feeding between 1-5 slm of N₂ or NH₃ into chamber 310 and disassociating the gas with microwaves at a power between. The tantalum organic precursor can be fed into chamber 350 by direct liquid injection or through the use of a bubbler.

It is to be appreciated that by utilizing the pre-nitrogen passivation step of the present invention, deposition of the metal-nitride film can begin by simply beginning the flow of the metal precursor into chamber 350 while activated nitrogen atoms continue to be fed from the nitrogen passivation step.

After a sufficiently thick metal-nitride film 212 is deposited the deposition is stopped. In an embodiment of the present invention a metal-nitride film 212 is formed to a thickness between 30-100Å.

In a preferred embodiment of the present invention, as set forth in block 114, and illustrated in Figure 2g after formation of a metal-nitride film, the metal nitride film is exposed to remotely generated activated nitrogen atoms. By exposing the metal-nitride film 212 to activated nitrogen atoms 214, nitrogen atoms are stuffed into the metal-nitride film 212. Stuffing the nitrogen atoms into the metal-nitride film prevents reaction of metal atoms (e.g., Ti or Ta) with oxygen which can lead to increased resistance of the metal-nitride film due to the incorporation of metal oxide compounds such as TiON and TaON.

A metal-nitride film can be stuffed with nitrogen atoms by feeding activated nitrogen atoms into deposition chamber 350 for between 10-60 seconds at a rate of between 1-5 slm while the substrate is heated to a temperature of between 350-450°C. Activated nitrogen atoms can be generated by feeding between 1-5 slm of N₂ or NH₃ into chamber 310 and disassociating the gas with microwaves or RF.

The next step of the present invention, as set forth in block 116 of flow chart 100 is to complete the processing of the device. For example, as shown in Figure 2e, a top capacitor electrode 216 can be formed over metal-nitride layer 212 if desired. Any well known technology can be used to form top electrode 216 including blanket depositing metal film such as tungsten over metal-nitride barrier layer 212 and then using well known photolithography and etching techniques to pattern the electrode film, the metal-nitride film 212 and dielectric layer 208. The use of a metal-nitride barrier 212 between a metal oxide dielectric film 208 such as tantalum pentaoxide, and a metal capacitor electrode 216 is desired because it prevents metal from the capacitor electrode 216 from pulling away oxygen molecules from metal-oxide dielectric 208 and creating charge vacancies which can lead to high leakage currents.

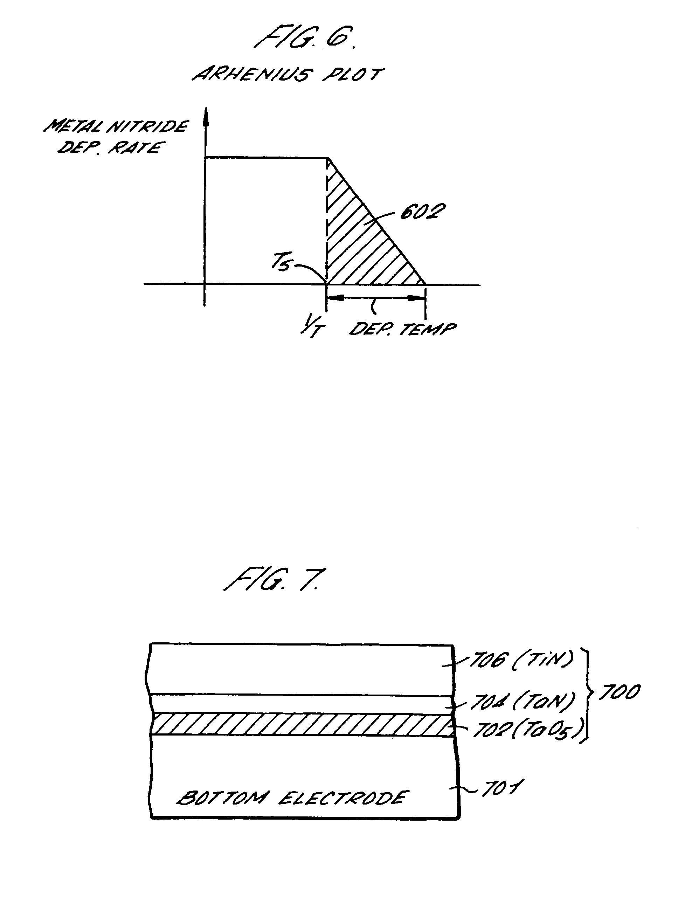

The process and method of the present invention can be used to fabricate a wide number of unique capacitor film stacks or structures which have been found to exhibit outstanding performance. In one embodiment of the present invention, a tantalum nitrided (TaN) film is formed between a tantalum pentaoxide (Ta₂O₅) film and a titanium nitride (TiN) film. For example, Figure 7 illustrates a composite stack 700 which includes a tantalum pentaoxide dielectric layer 702 formed over a bottom electrode. A tantalum nitride barrier layer 704 is formed on the tantalum pentaoxide dielectric layer. A top electrode 706, of titanium nitride or a top electrode having a titanium nitride bottom layer is then formed over the tantalum nitride barrier layer 704. The Ta₂O₅/TaN/TiN stack 700 has been found to exhibit extremely low leakage currents in capacitor DRAMs.

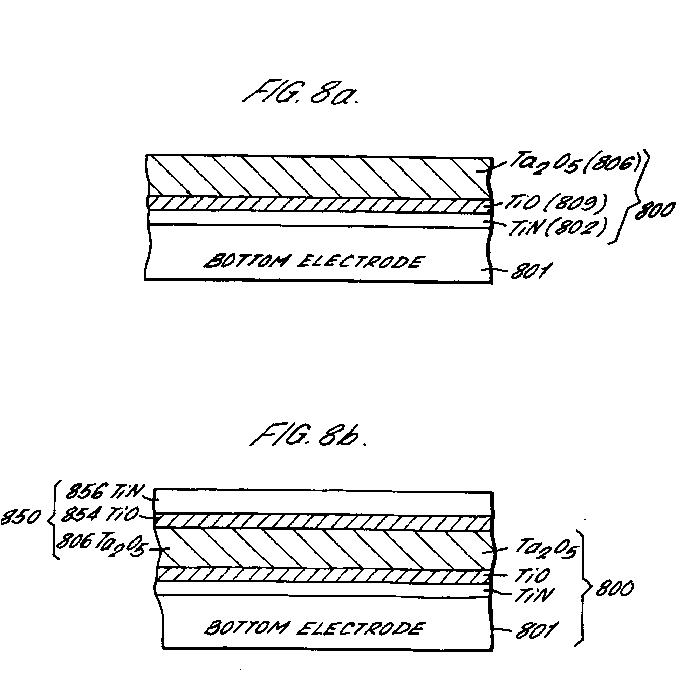

In another embodiment of the present invention, a titanium oxide (TiO) film is formed between a titanium nitride film and a tantalum pentaoxide (Ta₂O₅)
dielectric film. For example, Figure 8a illustrates a novel capacitor film stack 800 which includes a bottom electrode 801 having a titanium nitride film 802 form thereon. A titanium oxide (TiO) film 804 is formed on the titanium nitride film 802. A tantalum pentaoxide (Ta₂O₅) dielectric film 806 is formed on the titanium oxide film 804. In another embodiment, as shown in Figure 8b, a capacitor dielectric stack 850 includes a tantalum pentaoxide (Ta₂O₅) dielectric film 806. A titanium oxide (TiO) film 854 is formed on the tantalum pentaoxide (Ta₂O₅) dielectric film 806 and a titanium nitride (TiN) film 856 is formed on the titanium oxide (TiO) film 854. As is readily apparent, one can form a capacitor stack comprising both the stacks of Figures 8a and 8b to form a TiN/TiO/ Ta₂O₅/TiO/TiN capacitor. By including a titanium oxide film between the titanium nitride and the tantalum pentaoxide film, one can provide a capacitor stack with improved film interfaces which increases the capacitor performance and reliability.

Novel methods and apparatuses have been described which enable the formation and integration of high quality, high dielectric constant metal-oxide dielectric layers and high quality, low resistance metal-nitride layers at low temperatures, less than 500°C, and into high aspect ratio openings (greater than 2:1). The integrated process and apparatus of the present invention enable the fabrication of enhanced performance capacitors for ultra high density dynamic random access memories.

Thus, an integrated method and apparatus for forming an enhanced performance capacitor for a DRAM has been described.

## Claims

1. A method of fabricating a device, said method comprising the steps of:
placing a substrate having a metal or metal-containing film into a first process chamber;
generating active nitrogen atoms in a second chamber wherein said second chamber is separate from said first chamber;
exposing said metal or metal-containing film in said first chamber to said activated nitrogen atoms; and
forming a metal oxide dielectric on said activated nitrogen atom exposed metal or metal-containing film.

2. The method of claim 1, wherein said metal or metal-containing film is selected from tungsten, tungsten nitride, titanium nitride and titanium tungsten.

3. The method of claim 1 or claim 2, wherein said activated nitrogen atoms are formed form an anneal gas comprising or consisting of nitrogen (N₂) or ammonia (NH₃) .

4. A method of forming a semiconductor device, said method comprising the steps of:
forming a metal oxide dielectric over a substrate; forming a titanium oxide film on said metal oxide dielectric; and
forming a titanium nitride layer on said titanium oxide film.

5. The method of claim 4, wherein said metal oxide dielectric is selected from a piezoelectric and a ferroelectric.

6. A method of forming a semiconductor device, said method comprising the steps of:
forming a titanium nitride film over a substrate;
forming a titanium oxide film on said titanium nitride film; and
forming a metal oxide dielectric on said titanium oxide film.

7. The method of any one of claims 1 to 6, wherein said metal oxide dielectric is or comprises tantalum pentoxide (TaO₅).

8. The method of claim 7, further comprising the steps of:
forming a titanium oxide film on said tantalum pentoxide film; and
forming a titanium nitride film on said titanium oxide film.

9. A method of forming a capacitor, said method comprising the steps of:
providing a substrate having a bottom electrode; forming a metal-oxide dielectric film on said bottom electrode;
annealing said metal-oxide dielectric film with remotely generated active atomic species; and
forming a metal-nitride barrier layer on said annealed metal-oxide dielectric film.

10. The method of claim 9, further comprising the step of:
prior to forming said metal-nitride barrier layer, exposing said metal-oxide dielectric layer to remotely generated activated nitrogen atoms.

11. The method of claim 9 or claim 10, further comprising the step of:
after forming said metal nitride layer, exposing said metal-nitride barrier layer to remotely generated activated nitrogen atoms.

12. The method of any one of claims 9 to 11, wherein said bottom electrode is or comprises a metal electrode.

13. The method of any one of claims 9 to 12, further comprising the step of exposing said bottom electrode to remotely generated activated atomic species prior to forming said metal-oxide dielectric film.

14. A method of forming a capacitor, said method comprising the steps of:
placing a substrate having a bottom electrode in a processing chamber;
heating said substrate in said processing chamber; depositing a metal-oxide dielectric film on said bottom electrode in said processing chamber;
annealing said metal-oxide dielectric film in said processing chamber with activated atomic species formed in a disassociation chamber; and
forming a metal-nitride barrier layer on said annealed metal-oxide dielectric film in said processing chamber.

15. The method of claim 14, further comprising the step of exposing said bottom electrode in said processing chamber to an activated atomic species formed in said disassociation chamber prior to depositing said metal oxide dielectric.

16. The method of claim 14 or claim 15, further comprising the step of:
prior to forming said metal-nitride barrier layer, exposing said metal-oxide dielectric layer while in said processing chamber to activated nitrogen atoms formed in said disassociation chamber.

17. The method of any one of claims 14 to 16, further comprising the step of:
exposing said metal-nitride barrier layer while in said processing chamber to activated nitrogen atoms formed in said disassociation chamber.

18. The method of any one of claims 9 to 17, wherein said metal-oxide dielectric film is or comprises tantalum pentoxide (TaO₅).

19. The method of any one of claims 9 to 18, wherein said metal-nitride barrier layer is or comprises tantalum nitride (TaN).

20. The method of any one of claims 9 to 19, further comprising the step of forming a top electrode on said metal-nitride barrier layer.

21. The method of claim 20, wherein said top electrode is or comprises a lower titanium nitride (TiN) layer.

22. The method of any one of claims 9 to 21, wherein said metal-oxide dielectric film is formed by a method comprising the steps of:
providing a metal organic precursor into said processing chamber;
providing activated oxygen atoms into said processing chamber, wherein said activated oxygen atoms are formed by disassociating an oxygen containing gas in said disassociation chamber;
thermally decomposing said metal organic precursor in said processing chamber to form metal atoms; and
combining said metal atoms with said activated oxygen atoms to form said metal-oxide dielectric film.

23. The method of any one of claims 9 to 22, further comprising the step of exposing said bottom electrode to activated nitrogen atoms formed in said disassociation chamber.

24. A method of forming a capacitor, said method comprising the steps of:
placing a substrate having a bottom electrode in a first deposition chamber of a cluster tool;
forming a metal-oxide dielectric film on said bottom electrode in said first deposition chamber;
moving said substrate from said first deposition chamber through a transfer chamber to an anneal chamber while said transfer chamber is at a reduced pressure;
annealing said metal-oxide dielectric film in said anneal chamber with activated atomic species formed in a first disassociation chamber;
moving said substrate from said anneal chamber through said transfer chamber to a second deposition chamber while said transfer chamber is at a reduced pressure; and
forming a metal-nitride film on said annealed metal-oxide dielectric film.

25. The method of claim 24, wherein said metal-oxide dielectric film is formed by a method comprising the steps of:
providing a metal organic precursor into said first deposition chamber;
providing activated oxygen atoms into said first deposition chamber wherein said activated atoms are formed by disassociating an oxygen containing gas in a third disassociation chamber;
thermally decomposing said metal organic precursor in said first deposition chamber to form metal atoms; and combining said metal atoms with said activated oxygen atoms to form said metal-oxide dielectric film.

26. A method of forming a capacitor, said method comprising the steps of:
heating a substrate having a bottom electrode;
exposing said bottom electrode to remotely generated first active atomic species;
forming a metal-oxide dielectric film on said first active atomic species exposed bottom electrode;
annealing said metal-oxide dielectric film with remotely generated active oxygen atoms;
exposing said annealed metal-oxide dielectric layer to remotely generated active nitrogen atoms;
forming a metal-nitride barrier layer on said active nitrogen atom exposed metal-oxide dielectric film;
exposing said metal-nitride barrier layer to remotely generated active nitrogen atoms; and
forming a top gate electrode on said active nitrogen atom exposed metal-nitride barrier layer.

27. The method of any one of claims 1 to 26, further comprising the step of incorporating said device or said capacitor in a DRAM.
